# EUROPÄISCHE PATENTSCHRIFT

(11) **EP 1 961 126 B1**
(45) Veröffentlichungstag und Bekanntmachung des Hinweises auf die Patenterteilung: **15.08.2012**
(21) Anmeldenummer: 06819785.4
(22) Anmeldetag: 27.11.2006
(51) Int. Cl.: H04B 1/44

(54) **VERFAHREN ZUM BETREIBEN EINES KOMMUNIKATIONSENDGERÄTS**
METHOD FOR OPERATING A COMMUNICATION TERMINAL
PROCEDE POUR LE FONCTIONNEMENT D'UN APPAREIL DE COMMUNICATION

(30) Priorität: 08.12.2005 DE 102005058669
(43) Veröffentlichungstag der Anmeldung: 27.08.2008
(73) Patentinhaber: Hewlett-Packard Development Company, L.P., Houston, TX 77707 (US)
(72) Erfinder: BAUMANN, Stefan, 81547 München (DE); SIGG, Jakob, 85635 Höhenkirchen (DE)
(74) Vertreter: von Samson-Himmelstjerna, Friedrich
(86) Internationale Anmeldenummer: PCT/EP2006/068958
(87) Internationale Veröffentlichungsnummer: WO 2007/065810

(56) Entgegenhaltungen:
- WO-A-2004/110088
- WO-A2-2006/085139
- US-A1- 2003 228 892
- US-B1- 6 466 774

## Beschreibung

Die vorliegende Erfindung betrifft ein Verfahren zum Betreiben eines Kommunikationsendgeräts, sowie ein Kommunikationsendgerät selbst, das in der Lage ist, Rundfunksignale, wie beispielsweise des digitalen Fernsehens, zu empfangen und ferner in der Lage ist, eigene Funksignale zu senden.

Kommunikationsendgeräte, wie beispielsweise Mobiltelefone dienen heutzutage nicht mehr nur zum Telefonieren, sondern sind auf Grund der Miniaturisierung elektronischer Komponenten mit einer Vielzahl weiterer technischer Anwendungen ausgestattet. Beispielsweise haben moderne Mobiltelefone neben einem Funkmodul zur Kommunikation mit einem Mobilfunknetz, wie beispielsweise gemäß dem GSM(Global System for Mobile Communications)-Standard, ein weiteres Funkmodul zum Empfang von digitalem Fernsehen. Ein derartiges Funkmodul (Empfangsmodul) für das digitale Fernsehen kann beispielsweise gemäß dem DVB-H(Digital Video Broadcasting-Handheld)-Standard arbeiten.

Als Frequenzbereich für das mobile digitale Fernsehen gemäß dem DVB-H-Standard kommen zwei VHF (Very High Frequency)-Bänder (VHF 1: 46 MHz -68 MHz und VHF 3: 174 MHz - 230 MHz) und das UHF(Ultra High Frequency)-Band (470 MHz - 862 MHz) in Betracht. Zu Beginn der Einführung des digitalen Fernsehens wird gemäß der Standardisierungsgremien für DVB-H insbesondere das UHF-Band Anwendung finden, während in den VHF-Bändern digitales Fernsehen gemäß dem die DVB-T(Digital Video Broadcasting-Terrestrial)-Standard ausgestrahlt wird.

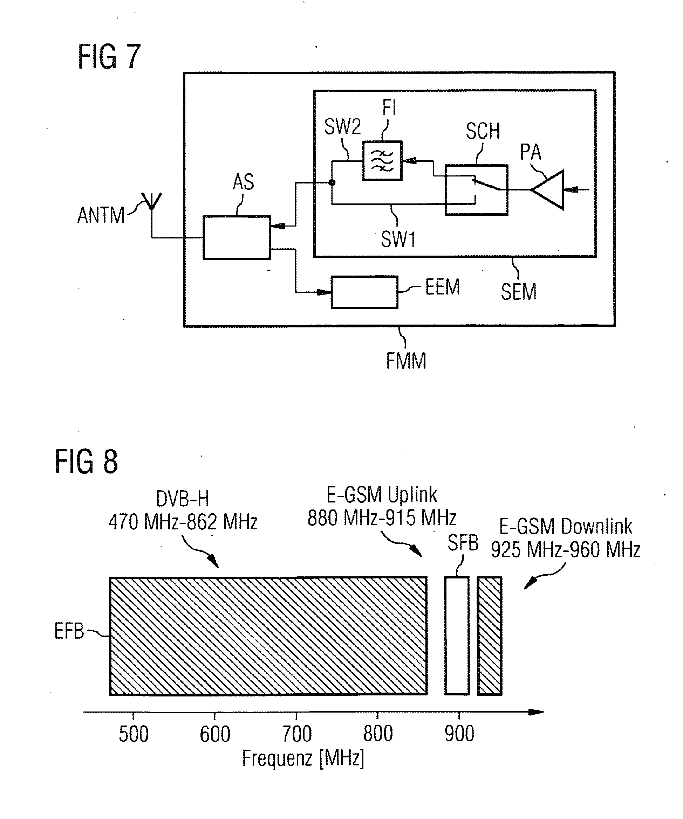

Für (mobile) Kommunikationsendgeräte, wie Mobiltelefone, die gleichzeitig DVB-H-Signale empfangen und in einem GSM-Netzwerk eingebucht sind, kann nun die Situation auftreten, dass das Gerät GSM-Signale mit einem Pegel bis zu +33 dBm im Frequenzbereich 890 MHz-910 MHz(bzw. 880 MHz - 915 MHz bei E-GSM) abstrahlt und gleichzeitig DVB-H-Signale bis zu einem Empfangspegel von -92 dBM bei einer Frequenz von 862 MHz detektieren bzw. erfassen können muss. Eine visuelle Veranschaulichung der Lage der einzelnen Frequenzbereiche zueinander ist in Figur 8 dargestellt. Dabei ist von links nach rechts die Frequenz in MHz aufgetragen. Im unteren dargestellten Frequenzbereich befindet sich das DVB-H-Band zwischen 470 MHz und 862 MHz. Darüber liegend befinden sich im Beispiel des E-GSM das E-GSM-Uplink-Band zwischen 880 MHz und 915 MHz, so wie das E-GSM-Downlink-Band zwischen 925 MHz und 960 MHz.

Problematisch bei mobilen Kommunikationsendgeräten, wie Mobiltelefonen, ist die Tatsache, dass die Antenne für das DVB-H-Funkmodul zum Empfangen der Rundfunksignale bzw. digitalen Fernsehsignale und die Antenne des GSM-Funkmoduls mit der Sendeeinrichtung zum Senden von GSM-Funksignalen auf Grund der meist geringen Abmessung der mobilen Kommunikationsendgeräte eine geringe räumliche Entfernung aufweisen und zu dem der Frequenzabstand von dem DVB-H-Empfangsband und dem GSM(E-GSM)-Sende-Frequenzband gering ist. Insbesondere in einem Betriebszustand des Kommunikationsendgeräts, bei dem sowohl das DVB-H-Empfangsmodul zum Empfangen von digitalen Fernsehsignalen aktiviert ist, und die Sendeeinrichtung des GSM-Funkmoduls aktiviert ist, ist es möglich, dass durch eine hohe abgestrahlte Sendeleistung des GSM-Funkmoduls eine Störung, und im schlimmsten Fall eine Zerstörung des DVB-H-Funkmoduls, insbesondere bezüglich des Eingangsverstärkers bzw. rauscharmen Verstärkers auftritt. Diese Störungen werden zum einen durch ein Rauschen des GSM-Sendesignals im DVB-H-Empfangsband verursacht und ferner durch eine Kompression des Eingangsverstärkers bzw. rauscharmen Verstärkers im DVB-H-Empfangsmodul durch das zu hohe GSM-Sendesignal.

Um nun die Störung des DVB-H-Empfangsmoduls zu minimieren, sind an die Rauschunterdrückung hohe Anforderungen zu stellen. Es ist dabei möglich, im GSM-Sendezweig einen Bandpassfilter zur Verringerung des sendeseitigen Rauschens vorzusehen. Jedoch ist dies zum einen eine kostspielige Lösung, die ferner eine höhere Verstärkung am sendeseitigen Leistungsverstärker erfordert, wodurch der Energieverbrauch des GSM-Funkmoduls erhöht wird und die Standzeit des Kommunikationsendgeräts verringert wird. Überdies ist eine Verringerung der Verkopplung zwischen dem GSM-Funkmodul und den DVB-H-Funkmodul durch Einsatz spezieller sendeseitiger Filter und/oder durch Einsatz spezieller Antennenkonzepte schwierig, da durch die sich ständig verändernde Umgebung eines mobilen Kommunikationsendgeräts nicht jeder Betriebszustand vorhersagbar ist (beispielsweise wenn ein mobiles Kommunikationsendgerät, wie ein Mobiltelefon, auf ein Autodach gelegt wird, usw.), wodurch es dann trotzdem zu einer Störung bzw. Zerstörung des die DVB-H-Empfangsmoduls kommen kann.

Aus der WO 2004/110 088 A1 ist eine Sende- und Empfangseinheit eines mobilen Endgeräts zum Senden von Signalen in einem ersten Frequenzband und zum Empfangen von Signalen in einem zweiten Frequenzband bekannt. Um die Leistungsfähigkeit der Empfangseinheit zu verbessern und Beeinträchtigungen des empfangenen Signals durch Interferenzeffekte, insbesondere verursacht durch gleichzeitig ausgesandte Signale zu verringern, wird zunächst Zeitmuster mit Zeitfenstern bestimmt, in denen Interferenzen im Empfangssignal auftreten. Dies geschieht basierend auf Informationen über das Sendemuster und die entsprechende Sendeleistung der Sendeeinheit. In Zeitfenstern, in denen die Sendeleistung hoch und das Signal-zu-Rausch-Verhältnis des empfangenen Signals aufgrund von Interferenzen so gering wäre, dass das empfangene Signal unter eine Detektionsschranke sinken würde, wird der Verstärkungsgrad eines VGA entsprechend der aktuellen Sendeleistung erhöht, sodass der Nutzanteil des Signals detektiert werden kann.

Somit ist es die Aufgabe der vorliegenden Erfindung, eine einfache Möglichkeit zum Betreiben eines Kommunikationsendgeräts zu schaffen, bei der der Empfang eines Nutzsignals optimiert und die Gefahr einer Zerstörung beim Empfang von Rundfunksignalen durch eine Sendeeinrichtung minimiert wird.

Diese Aufgabe wird durch die unabhängigen Ansprüche gelöst. Vorteilhafte Ausgestaltungen sind Gegenstand der Unteransprüche.

Dabei umfasst ein Verfahren zum Betreiben eines Kommunikationsendgeräts, welches eine Empfängerkette mit zumindest einem Empfängerbauteil und einer diesem vorgeschalteten Verstärkereinrichtung zum Empfangen von in ersten Zeitabschnitten gesendeten Rundfunksignalen in einem vorbestimmten Frequenzband, sowie eine Sendeeinrichtung zum Senden von Funksignalen aufweist, folgende Schritte. Es wird das beim Senden der Funksignale in dem Frequenzband der Empfängerkette auftretende Rauschen in der Empfängerkette gemessen. Anschließend wird die Verstärkung der Verstärkereinrichtung in Abhängigkeit des gemessenen Rauschens derart eingestellt, dass ein maximaler an dem Empfängerbauteil anliegender Signalpegel nicht überschritten wird.

Auf diese Weise kann der Einfluss des Rauschens beim Senden von Funksignalen seitens der Sendeeinrichtung auf die Empfängerkette gemessen bzw. ermittelt werden und dann entsprechend die Verstärkung der Verstärkerkette derart (niedrig) eingestellt werden, dass eine Zerstörung des Empfängerbauteils nicht mehr möglich ist. Auf Grund der Messung bzw. Ermittlung des Rauschens in der Empfängerkette beim Senden von Funksignalen durch die Sendeeinrichtung kann andererseits jedoch die Verstärkung an der Verstärkereinrichtung derart (hoch) eingestellt werden, dass ein optimaler Nutzsignalempfang gewährleistet ist. Das bedeutet durch das beschriebene Verfahren ist es möglich, eine Kompromisslösung aus bestmöglichem Empfang von Nutzsignalen (hier Rundfunksignalen) und einem Sicherheitsbedürfnis zur Verhinderung der Zerstörung der Empfängerkette herzustellen.

Gemäß einer vorteilhaften Ausgestaltung wird das Messen des Rauschens in der Empfängerkette in ersten Zwischenzeitabschnitten durchgeführt, welche zwischen den ersten Zeitabschnitten liegen. Das bedeutet, das Messen des Rauschens findet dann statt, wenn gerade keine Rundfunksignale von Empfängerkette empfangen werden bzw. empfangen werden sollen. Dies hat den Vorteil, dass ein Messen des Rauschens zu keiner Beeinträchtigung des Empfangens bzw. Verarbeitens von Nutzsignalen bzw. Rundfunksignalen führt.

Gemäß einer weiteren vorteilhaften Ausgestaltung sendet die Sendeeinrichtung die Funksignale in zweiten, insbesondere sich wiederholenden Zeitabschnitten, welche zumindest teilweise mit den ersten Zeitabschnitten überlappen. Dabei ist es möglich, dass die Sendeeinrichtung gemäß einem Mobilfunkstandard arbeitet, wie beispielsweise gemäß dem GSM-Standard. Bei diesem Mobilfunkstandard werden zu bestimmten Zeitpunkten während der zweiten Zeitabschnitte die Funksignale in so genannten Sende-Bursts von der Sendeeinrichtung zu einer Basisstation eines Mobilfunknetzes gesandt, wobei diese SendeBursts schließlich die Ursache für eine Störung des Empfangs von Rundfunksignalen in der Empfängerkette darstellen können. Es ist jedoch auch möglich, dass die Sendeeinrichtung nach dem UMTS(Universal Mobile Telecommunications System)-Standard arbeitet, bei dem an Stelle des Sendens der Funksignale in zweiten Zeitabschnitten ein kontinuierliches Senden von Funksignalen stattfindet.

Gemäß einer weiteren vorteilhaften Ausgestaltung wird die Messung bzw. Ermittlung des Rauschens wiederholt durchgeführt. Dabei ist es möglich, das Messen des Rauschens in regelmäßigen Zeitabständen durchzuführen. Bei einer Ausgestaltung, bei der die Sendeeinrichtung in der Lage ist, die Sendefrequenz, auf der sie Funksignale sendet, zu variieren, kann das Messen des Rauschens dann durchgeführt werden, nach dem die Sendeeinrichtung die Sendefrequenz geändert hat. Vorteilhafter Weise findet das Messen in den ersten Zwischenzeitabschnitten statt, welche zwischen den ersten Zeitabschnitten liegen. Es ist ferner möglich, dass die Sendeeinrichtung in der Lage ist, die Sendeleistung, mit der sie die Funksignale sendet, zu variieren, wobei das Messen des Rauschens dann durchgeführt wird, nachdem die Sendeeinrichtung die Sendeleistung geändert hat. Vorteilhafter Weise findet auch hier wiederum das Messen des Rauschens in den ersten Zwischenzeitabschnitten nach der Änderung der Sendeleistung statt. Es ist ferner auch möglich, dass die Empfängerkette in der Lage ist, die Empfangsfrequenz, auf der ein bestimmter Rundfunkdienst bzw. bestimmte diesem zugeordnete Rundfunksignale empfangen wird/werden, innerhalb des Frequenzbands zu variieren, wobei das Messen des Rauschens dann durchgeführt wird, nachdem die Empfängerkette die Empfangsfrequenz geändert hat. Auch hier findet das Messen vorteilhafter Weise in den ersten Zwischenzeitabschnitten nach dem Ändern der Empfangsfrequenz statt.

Gemäß einer weiteren vorteilhaften Ausgestaltung wird vor dem Durchführen des Messens des Rauschens die Verstärkung der Verstärkereinrichtung auf einen maximal möglichen Wert eingestellt, bei dem keine Zerstörung des Empfängerbauteils während der Messung eintritt. Das bedeutet, um eine Beschädigung des Empfängerbauteils zu vermeiden, wird die Verstärkung der Verstärkereinrichtung für das Messen des Rauschens so unempfindlich eingestellt, dass eine Beschädigung des nachfolgenden Empfängerbauteils bzw. der darauf folgenden Empfängerkettenkomponenten (bei einem maximal zu erwartenden Signalpegel bzw. Rauschsignalpegel) sicher verhindert wird. Nach einer Messung des Rauschens bzw. des Rauschpegels in der Empfängerkette auf Grund eines Funksignals der Sendeeinrichtung ist der Rauschpegel, der durch die Sendeeinrichtung verursacht wird, bekannt, so dass die Verstärkung der Verstärkereinrichtung wieder wie oben derart eingestellt werden kann, dass zum einen der von der Empfängerkette empfangene Nutzsignalpegel (der Rundfunksignale) optimiert wird, während gleichzeitig jedoch eine Zerstörung der Empfängerkette, insbesondere des Empfängerbauteils durch Funksignale von der Sendeeinrichtung verhindert wird.

Gemäß einer weiteren vorteilhaften Ausgestaltung zur Verbesserung des Empfangs des Nutzsignals umfasst die Empfängerkette ferner ein einstellbares Bandpassfilter zum Durchlassen eines gewünschten Frequenzbands, wobei das Bandpassfilter in Abhängigkeit des gemessenen Rauschens derart bezüglich des Frequenzbands eingestellt wird, dass das durch das Senden der Funksignale verursachte Rauschen in der Empfängerkette minimiert wird. Dabei soll die Einstellung des Bandpassfilters derart erfolgen, dass bei einer maximalen Empfindlichkeit für den Empfang von den Rundfunksignalen das Rauschen in der Empfängerkette minimiert wird.

Gemäß einer weiteren vorteilhaften Ausgestaltung zur Verbesserung des Empfangs von Nutzsignalen bzw. Rundfunksignalen hat die Empfängerkette eine abstimmbare, insbesondere schmalbandige Antenne zum Empfangen eines gewünschten Frequenzbands, wobei die Antenne in Abhängigkeit des gemessenen Rauschens derart bezüglich des Frequenzbands eingestellt wird, dass das durch das Senden der Funksignale verursachte Rauschen in der Empfängerkette minimiert wird. Insbesondere ist die Einstellung der Antenne derart vorzunehmen, dass bei maximaler Empfindlichkeit für den Empfang von Rundfunksignalen das durch das Senden der Funksignale verursachte Rauschen in der Empfängerkette minimiert wird.

Gemäß einer weiteren vorteilhaften Ausgestaltung werden bei dem Messen des Rauschens die spektralen Eigenschaften des Rauschens ermittelt, wobei die Linearität der Verstärkereinrichtung in Abhängigkeit von ermittelten spektralen Maxima, wie beispielsweise Spuren usw., eingestellt wird. Hierdurch wird eine Verzerrung der Rundfunksignale bzw. der Nutzsignale erreicht.

Gemäß einer weiteren vorteilhaften Ausgestaltung umfasst die Sendeeinrichtung ein zuschaltbares sendeseitiges Bandpassfilter, das in Abhängigkeit des gemessenen Rauschens in den Sendepfad der Sendeeinrichtung, vorzugsweise einem Leistungsverstärker zum Verstärken des Sendesignalen nachgeschaltet, zugeschaltet wird, so dass das durch das Senden der Funksignale verursachte Rauschen in der Empfängerkette minimiert wird. Dabei kann die Sendeeinrichtung bzw. das zuschaltbare Bandpassfilter derart betrieben werden, dass standardmäßig (wenn die Empfängerkette nicht aktiviert ist bzw. keine Rundfunksignale empfängt) das zuschaltbare Bandpassfilter nicht in den Sendepfad geschaltet wird, während bei aktivierter Empfängerkette und bei gleichzeitiger Messung eines Rauschpegels über einen maximalen Schwellenwert hinaus das zuschaltbare Bandpassfilter in den Sendepfad der Sendeeinrichtung geschaltet wird, um damit den Rauschpegel in der Empfängerkette zu minimieren. Es ist jedoch auch möglich, die Sendeeinrichtung derart zu betreiben, dass das Bandpassfilter standardmäßig (bei deaktivierter Empfängerkette) nicht in dem Sendepfad der Sendeeinrichtung zugeschaltet wird, während bei Aktivierung der Empfängerkette zum Empfangen von Rundfunksignalen immer gleichzeitig das zuschaltbare Bandpassfilter in den Sendezweig der Sendeeinrichtung geschaltet wird (also unabhängig von dem gemessenen Rauschpegel).

Die von der Empfängerkette empfangenen Rundfunksignale können dabei digitale Fernsehsignale oder Radiosignale umfassen. Insbesondere können die Rundfunksignale digitale Fernsehsignale gemäß dem DVB(Digital Video Broadcasting)-Standard umfassen. Für den Betrieb von mobilen Kommunikationsendgeräten, die zumeist nur eine kleine oder begrenzte Energiequelle (Akku) aufweisen, ist die Verwendung bzw. der Empfang von digitalen Fernsehsignalen gemäß dem die DVB-H-Standard vorteilhaft. Die Übertragung der DVB-H-Rundfunksignale an das Kommunikationsendgerät erfolgt dabei für einen bestimmten DVB-H-Dienst bzw. ein bestimmtes DVB-H-Programm in den ersten Zeitabschnitten, welche eine Länge zwischen 20 Millisekunden und mehreren Sekunden aufweisen können, wobei die ersten Zeitabschnitte dann durch mehrsekundige Sende- bzw. Empfangspausen (Zwischenzeitabschnitte) unterbrochen sind. Es ist jedoch auch denkbar, dass die empfangenen Rundfunksignale digitale Radiosignale beispielsweise im Rahmen des DAB (DAB: Digital Audio Broadcasting) umfassen. Sollte sich bei dem Messen des Rauschens bzw. Rauschpegels herausstellen, dass die Störung bzw. der Rauschpegel durch die von der Sendeeinrichtung gesendeten Funksignale sehr viel größer als der Empfangspegel der Rundfunksignale ist (einerseits misst die Empfängerkette den Rauschpegel in den ersten Zwischenzeitabschnitten des durch die Funksignale der Sendeeinrichtung verursachten Rauschens, und andererseits misst die Empfängerkette den Signalpegel bzw. Nutzsignalpegel in den ersten Zeitabschnitten beim Empfang der Rundfunksignale, vorteilhafterweise wenn keine Funksignale gesendet werden), so können die Messergebnisse (des Rauschsignalpegels und des Nutzsignalpegels) dazu verwendet werden, einem Benutzer des Kommunikationsendgeräts einen akustischen und/oder visuellen und/oder mechanischen (beispielsweise durch Vibration) Hinweis zu geben, dass der Empfang von Rundfunksignalen im Folgenden gestört sein kann bzw. abbrechen wird.

Des Weiteren ist es denkbar, dass auf Grund der Messung des Rauschpegels auf Grund des Sendens von Funksignalen seitens der Sendeeinrichtung gegenüber dem Nutzsignalpegel die Sendeleistung der Sendeeinrichtung zumindest temporär (um eine oder mehrere Leistungsstufen) verringert werden kann, zumindest so lange, bis eine mit dem Kommunikationsendgerät bzw. der Sendevorrichtung in Verbindung stehende Basisstation (insbesondere bei einer Mobilfunkverbindung) mehr Sendeleistung von der Sendeeinrichtung fordert.

Gemäß einem weiteren Aspekt der Erfindung wird ein Kommunikationsendgerät, insbesondere zum Durchführen eines oben beschriebenen Verfahrens bzw. einer Ausgestaltung hiervon geschaffen. Dabei hat das Kommunikationsendgerät eine Empfängerkette, welche zumindest ein Empfängerbauteil und eine diesem vorgeschaltete Verstärkereinrichtung zum Empfangen von in ersten Zeitabschnitten gesendeten Rundfunksignalen in einem vorbestimmten Frequenzband umfasst. Ferner hat das Kommunikationsendgerät eine Sendeeinrichtung zum Senden von Funksignalen. Außerdem hat es eine Steuereinrichtung, die mit der Empfängerkette verbunden ist und dafür eingerichtet ist, das beim Senden der Funksignale in dem Frequenzband der Empfängerkette auftretende Rauschen in der Empfängerkette zu ermitteln, und die Verstärkung der Verstärkereinrichtung in Abhängigkeit des ermittelten Rauschens derart einzustellen, dass ein maximaler an dem Empfängerbauteil anliegender Signalpegel nicht überschritten wird. Insbesondere ist es dabei möglich, vor dem Empfang von Rundfunksignalen das durch die Sendeeinrichtung beim Senden von Funksignalen auftretende Rauschen in der Empfängerkette zu messen bzw. zu ermitteln und somit die Empfängerkette bzw. die Verstärkereinrichtung so einzustellen, dass keine Zerstörung durch die Sendeeinrichtung eintritt, gleichzeitig aber die Empfängerkette bzw. die Verstärkereinrichtung auf maximale Empfindlichkeit für dem Empfang der Rundfunksignale eingestellt wird.

Gemäß einer vorteilhaften Ausgestaltung ist die Steuereinrichtung derart eingerichtet, das Ermitteln des Rauschens in der Empfängerkette in ersten Zwischenzeitabschnitten durchzuführen, welche zwischen den ersten Zeitabschnitten liegen. Insbesondere jedoch kann, wie oben bereits erwähnt, das Ermitteln des Rauschens bereits vor dem Empfang eines Rundfunksignals bzw. vor einem ersten Zeitabschnitt stattfinden, so dass die Verstärkung (bzw. die Empfindlichkeit) der Empfängerkette schon optimal für den Empfang von Rundfunksignalen eingestellt wird, ohne eine Beschädigung der Empfängerkette zu riskieren.

Gemäß einer weiteren vorteilhaften Ausgestaltung ist die Sendeeinrichtung derart ausgelegt, die Funksignale in zweiten Zeitabschnitten zu senden. Dabei ist es möglich, dass die zweiten Zeitabschnitte mit den ersten Zeitabschnitten zumindest teilweise überlappen. Abhängig vom jeweiligen Funkstandard, nach dem die Sendeeinrichtung arbeitet, ist es auch möglich, dass die zweiten Zeitabschnitte periodisch aufeinander folgen und durch zweite Zwischenzeitabschnitte unterbrochen werden. Insbesondere bei einem Betrieb der Sendeeinrichtung gemäß dem GSM-Standard findet hier ein burstweises Senden der Funksignale zu einer entsprechenden Mobilfunk-Basisstation während der zweiten Zeitabschnitte regelmäßig statt.

Gemäß einer weiteren vorteilhaften Ausgestaltung ist die Steuereinrichtung derart ausgelegt, das Ermitteln des Rauschens in der Empfängerkette wiederholt durchzuführen. Dabei kann das Ermitteln des Rauschens in regelmäßigen Zeitabschnitten durchgeführt werden. Es kann aber auch in Abhängigkeit von bestimmten Sendeparametern durchgeführt werden. Beispielsweise wenn die Sendeeinrichtung in der Lage ist, ihre Sendefrequenz, auf der sie die Funksignale sendet, zu variieren, kann die Steuereinrichtung das Ermitteln des Rauschens dann durchführen, nachdem die Sendeeinrichtung die Sendefrequenz geändert hat. Entsprechend ist es möglich, dass die Sendeeinrichtung ihre Sendeleistung variiert, so dass die Steuereinrichtung dann das Ermitteln des Rauschens durchführt, nachdem die Sendeeinrichtung ihre Sendeleistung geändert hat. Das Ermitteln des Rauschens kann jedoch auch in Abhängigkeit von Empfangsparametern durchgeführt werden. Dabei ist es möglich, dass die Empfängerkette in der Lage ist, ihre Empfangsfrequenz, auf der ein bestimmter Rundfunkdienst bzw. dessen zugeordnete Rundfunksignale empfangen werden, innerhalb des Frequenzbands zu variieren, wobei die Steuereinrichtung das Ermitteln des Rauschens dann durchführt, nachdem die Empfängerkette die Empfangsfrequenz geändert hat.

Gemäß einer weiteren vorteilhaften Ausgestaltung ist die Steuereinrichtung derart ausgelegt, vor dem Durchführen des Ermittelns des Rauschens die Verstärkung der Verstärkereinrichtung auf einen maximal möglichen Wert einzustellen, bei dem keine Zerstörung des Empfängerbauteils während der Messung eintritt. Anders ausgedrückt wird die Verstärkereinrichtung auf einen derartigen unempfindlichen (maximal noch möglichen) Wert eingestellt, bei dem eine Zerstörung des Empfängerbauteils ausgeschlossen werden kann. Nach der Messung kann dann entsprechend die Verstärkung derart eingestellt werden, dass bei einem gleichzeitigen Betrieb der Empfängerkette und der Sendeeinrichtung die maximale Empfindlichkeit für den Empfang von Rundfunksignalen eingestellt wird, ohne eine Zerstörung der Empfängerkette durch das beim Senden von Funksignalen verursachte Rauschen zu riskieren.

Gemäß einer weiteren vorteilhaften Ausgestaltung hat die Empfängerkette ferner ein einstellbares Bandpassfilter zum Durchlassen eines gewünschten Frequenzbands, wobei die Steuereinrichtung das Bandpassfilter in Abhängigkeit des gemessenen Rauschens derart bezüglich des Frequenzbands einstellt, dass das durch das Senden der Funksignale verursachte Rauschen in der Empfängerkette minimiert wird. Des Weiteren kann die Empfängerkette ferner eine abstimmbare (schmalbandige) Antenne zum Empfangen eines gewünschten Frequenzbands aufweisen, wobei die Steuereinrichtung die Antenne in Abhängigkeit des gemessenen Rauschens derart bezüglich des Frequenzbands einstellt, dass das durch das Senden der Funksignale verursachte Rauschen in der Empfängerkette minimiert wird. Überdies ist es möglich, dass beim Ermitteln des Rauschens ferner die spektralen Eigenschaften des Rauschens ermittelt werden, wobei die Steuereinrichtung dann die Linearität der Verstärkereinrichtung in Abhängigkeit von ermittelten spektralen Maxima, wie beispielsweise Spuren, einstellt. Die Sendeeinrichtung kann ferner ein zuschaltbares sendeseitiges Bandpassfilter aufweisen, wobei die Steuereinrichtung das sendeseitige Bandpassfilter in Abhängigkeit des gemessenen Rauschens in den Sendepfad der Sendeeinrichtung, vorzugsweise einem Leistungsverstärker zum Verstärken des Sendesignalen nachgeschaltet, zuschaltet, so dass das durch das Senden der Funksignale verursachte Rauschen in der Empfängerkette minimiert wird.

Das Kommunikationsendgerät kann dabei als ein tragbares Gerät ausgebildet sein, insbesondere als ein Mobilfunkgerät, ein Mobiltelefon oder als ein tragbarer Computer mit Funkmodul.

Bevorzugte Ausführungsformen der vorliegenden Erfindung werden nachfolgend Bezug nehmend auf die beiliegenden Zeichnungen näher erläutert. Es zeigen:
- Figur 1: eine schematische Darstellung eines Mobiltelefons als Kommunikationsendgerät in einer Telekommunikationsanordnung, bei der das Mobiltelefon mit einer Rundfunkstation, sowie mit einer Mobilfunk-Basisstation in Verbindung steht.
- Figur 2: eine vereinfachte schematische Darstellung einer Empfängerkette zum Empfangen von Rundfunksignalen, sowie einer Sende-/Empfangseinrichtung zum Senden und Empfangen von Mobilfunksignalen;
- Figur 3: eine zeitliche Struktur zum Veranschaulichen von ersten Zeitabschnitten, in denen Rundfunksignale gemäß dem DVB-H-Standard empfangen werden, und von zweiten Zeitabschnitten, in denen Mobilfunksignale gemäß dem GSM-Standard gesendet werden;
- Figur 4: eine erste bevorzugte Ausführungsform einer Empfängerkette zur Verbesserung des Empfangs von Rundfunksignalen;
- Figur 5: eine zweite bevorzugte Ausführungsform einer Empfängerkette zur Verbesserung des Empfangs von Rundfunksignalen;
- Figur 6: eine dritte bevorzugte Ausführungsform einer Empfängerkette zur Verbesserung des Empfangs von Rundfunksignalen;
- Figur 7: eine bevorzugte Ausführungsform einer Sendeeinrichtung zur Verbesserung des Empfangs von Rundfunksignalen in einer Empfängerkette, welche mit der Sendeeinrichtung in einem Kommunikationsendgerät angeordnet ist;
- Figur 8: eine schematische Darstellung von verwendeten Frequenzbändern gemäß dem DVB-H-Standard und dem E-GSM(Extended Global System for Mobile Communication)-Standard.

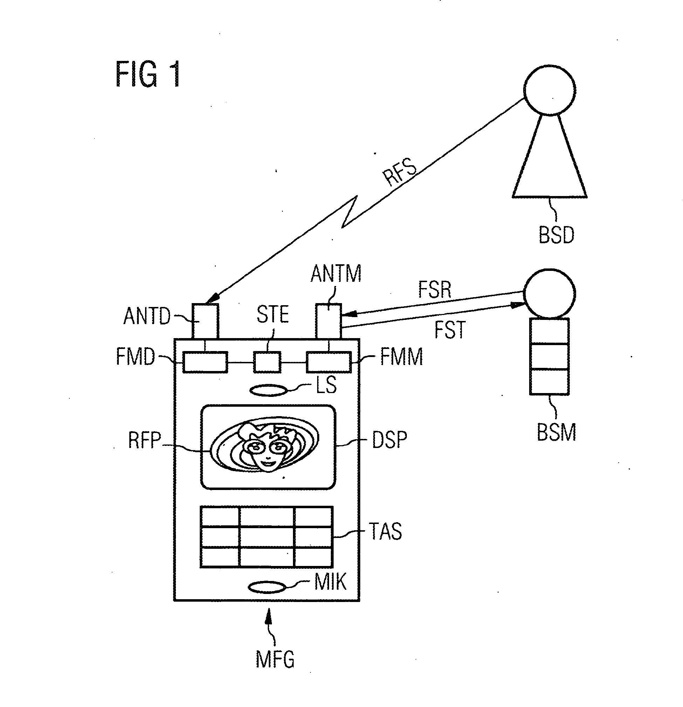

Es sei zunächst auf Figur 1 verwiesen, in der eine Telekommunikationsanordnung gezeigt ist. Die Telekommunikationsanordnung umfasst dabei eine Rundfunkstation bzw. eine Rundfunk-Basisstation BSD zum Abstrahlen von Rundfunksignalen RFS in Form von digitalen Fernsehsignalen gemäß dem DVB-H-Standard.
Des Weiteren umfasst die Telekommunikationsanordnung eine Basisstation BSM eines Mobilfunknetzes, das gemäß der Ausführungsform nach dem GSM- bzw. E-GSM-Standard arbeitet. Die Basisstation BSM ist dabei in der Lage, mit mobilen Kommunikationsendgeräten, wie Mobiltelefonen eine Funkverbindung aufzubauen und dazu Funksignale FSR an ein jeweiliges Kommunikationsendgerät bzw. Mobiltelefon zu senden und Funksignale FST vom jeweiligen Kommunikationsendgerät bzw. Mobiltelefon zu empfangen.

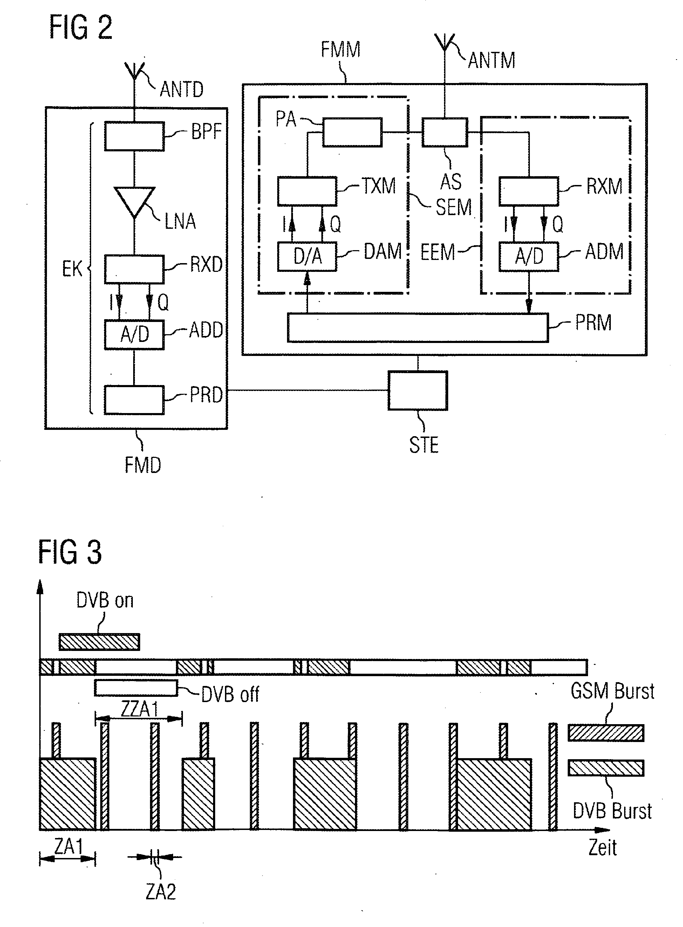

Schließlich umfasst die Telekommunikationsanordnung ein Kommunikationsendgerät in der Form eines Mobiltelefons MFG. Dieses Mobiltelefon MFG hat einen Lautsprecher LS zum Ausgeben von akustischen Signalen, wie Tönen, Sprache oder Geräuschen, und hat entsprechend ein Mikrofon MIK zum Erfassen von akustischen Signalen. Überdies hat das Mobiltelefon MFG eine Tastatur TAS zum Eingeben von Steueranweisungen bzw. Schriftzeichen. Um nun die Rundfunksignale RFS der Basisstation BSD, und somit digitales Fernsehen empfangen zu können, hat das Mobiltelefon MFG eine Antenne ANTD, welche mit einem Funkmodul FMD verbunden ist. Das Funkmodul FMD umfasst eine Empfängerkette (wie sie ausführlich in Figur 2 dargestellt ist), welche in der Lage ist, die Rundfunksignale RFS zu verarbeiten und die verarbeiteten (digitalisierten) Signale an eine Anzeigeeinrichtung DSP weiterzuleiten, damit dort die in den Rundfunksignalen RFS enthaltenen Nutzdaten in Form eines Fernsehbilds dargestellt werden können. Gemäß der Ausführungsform wird auf der Anzeige DSP gerade ein empfangenes Fernsehprogramm RFP, repräsentiert durch den Kopf in der Mitte der Anzeige, angezeigt.

Zum Kommunizieren mit der Basisstation BSM des Mobilfunknetzes hat das Mobiltelefon MFG ferner eine Antenne ANTM, die in der Lage ist, Funksignale FST zur Basisstation BSM zu senden, und Funksignale FSR von der Basisstation BSM zu empfangen. Dabei ist die Antenne ANTM mit einem Funkmodul FMM verbunden, das in der Lage ist, Funksignale gemäß dem GSM-Standard zu erzeugen und auch zu empfangen und zu verarbeiten.

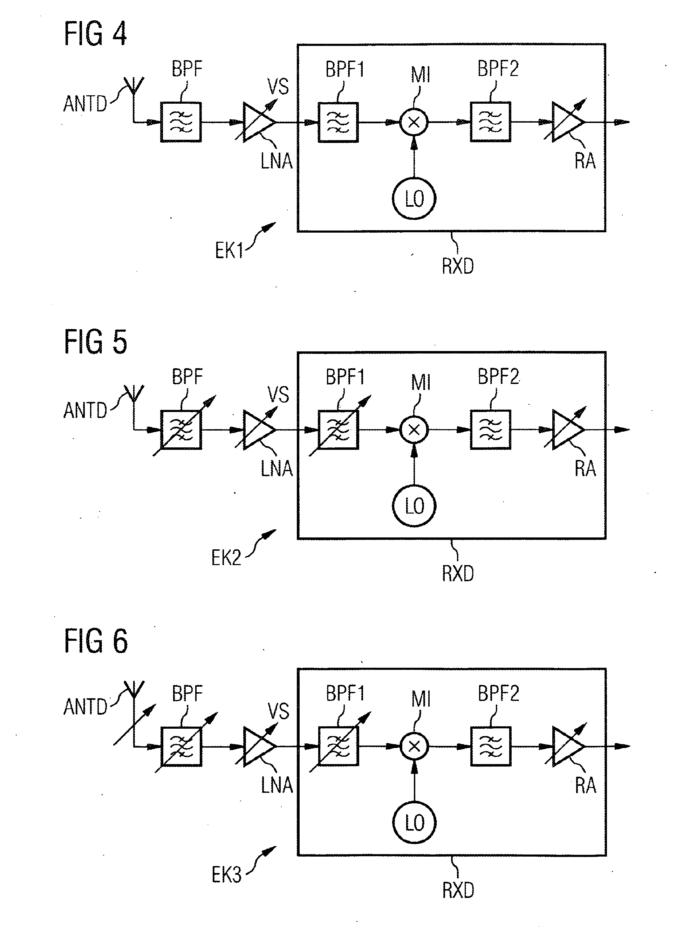

Schließlich umfasst das Mobiltelefon MFG noch eine Steuereinrichtung STE, die sowohl mit dem Funkmodul FMM, als auch dem Funkmodul FMD verbunden ist. Von dem Funkmodul FMM erhält die Steuereinrichtung Sendeparameter, wie beispielsweise die zeitliche Struktur des Sendens von Funksignalen FST, die Sendeleistung, mit der die Funksignale FST abgestrahlt werden, sowie die Sendefrequenz bzw. das Sendefrequenzband, mit dem die Funksignale FST abgestrahlt werden. Von dem Funkmodul FMD erhält die Steuereinrichtung Empfangsparameter, wie die zeitliche Struktur des Empfangens von Rundfunksignalen RFS, die Signalfeldstärke, mit der die Rundfunksignale RFS empfangen werden, sowie die Empfangsfrequenz bzw. das Empfangsfrequenzband, in dem die Rundfunksignale empfangen werden. Wie es unten bezüglich der Figuren 4 bis 7 erläutert werden wird, ist die Steuereinrichtung STE auf Grund der Messung bzw. Ermittlung des Rauschens in der Empfängerkette durch das Senden von Funksignalen seitens der Sendeeinrichtung in der Lage, das Funkmodul FMD bzw. die in diesem enthaltene Empfängerkette derart anzusteuern, dass eine Optimierung des Empfangs von Rundfunksignalen in der Empfängerkette bei minimierter Gefahr der Zerstörung erreicht wird.

Es sei nun auf Figur 2 verwiesen, in der der Funkabschnitt des Mobiltelefons, bestehend aus den Funkmodulen FMM und FMD, sowie der Steuereinrichtung STE, ausführlicher schematisch dargestellt ist. Ausgehend von der Antenne ANTD umfasst eine in dem Funkmodul FMD vorgesehene Empfängerkette bzw. Empfangskette EK des Funkmoduls FMD zunächst ein Bandpassfilter BPF zum Durchlassen eines spezifischen Empfangsfrequenzbands. Ein durch das Bandpassfilter BPF gefiltertes Rundfunksignal trifft dann auf einen rauscharmen Verstärker LNA zum Verstärken des gefilterten Rundfunksignals. Dieses verstärkte (analoge) Rundfunksignal wird dann dem Empfängerbauteil bzw. Empfangsbauteil RXD zur weiteren Verarbeitung (weitere Verstärkung, Filterung, Demodulation, usw.) zugeführt. Die aus der Demodulation gewonnenen Komponenten I und Q (In-Phase-Signalanteil und Quadratur-Signalanteil im Rahmen einer I/Q-Modulation) werden dann einem Analog-Digital-Wandler ADD zugeführt, der schließlich die zugeführten analogen Signale in digitale Signale umwandelt. Diese digitalen Signale werden dann einem Prozessor PRD zugeführt, der schließlich eine Verarbeitung der Signale im Basisband durchführt. Die oben genannten Empfangsparameter erhält die Steuereinrichtung beispielsweise von der Prozessoreinrichtung PRD. Es sei bemerkt, dass oben als Empfangsparameter die Signalfeldstärke genannt wurde, mit der die Rundfunksignale RFS von dem Funkmodul FMD bzw. der Empfängerkette EK empfangen werden. Das bedeutet, die Empfängerkette ist in der Lage, die Signalfeldstärke von Signalen zu messen bzw. zu ermitteln, die innerhalb des Empfangsfrequenzbands auftreten. So ist die Empfängerkette auch in der Lage, das Rauschen zu messen bzw. zu ermitteln, das durch das Senden von Funksignalen durch die Sendeeinrichtung SEM in der Empfängerkette EK wahrgenommen wird. Neben dem Rauschpegel ist es auch möglich, mit der Empfängerkette die spektralen Eigenschaften des Rauschens zu analysieren. Somit können die von der Empfängerkette gemessenen Rauschparameter (Pegel, Spektrum) beispielsweise von der Prozessoreinrichtung PRD an die Steuereinrichtung STE übertragen werden, damit die Steuereinrichtung STE in Abhängigkeit der erfassten Rauschparameter das Funkmodul FMM bzw. das Funkmodul FMD derart einstellen kann, um einen optimalen Empfang von Rundfunksignalen durch das Funkmodul FMD zu erreichen.

Das Funkmodul FMM umfasst ausgehend von der Antenne ANTM einen Antennenschalter AS, der sowohl mit einer Sendeeinrichtung SEM, als auch einer Empfangseinrichtung EEM des Funkmoduls FMM verbunden ist. In vereinfachter Darstellung umfasst die Empfangseinrichtung EEM ein Empfängerbauteil bzw. Empfangsbauteil RXM zum Verarbeiten der empfangenen Funksignale FSR (zum Filtern, Verstärken, Demodulieren, usw.). Die analogen Signalanteile I und Q der verarbeiteten Funksignale FSR werden dann einem Analog-Digital-Wandler ADM zugeführt, der die analogen Signale in digitale Signale umsetzt und diese digitalen Signale schließlich einer Prozessoreinrichtung PRM zuführt, die schließlich eine Verarbeitung der Signale in dem Basisband vornimmt. Ausgehend von der Prozessoreinrichtung PRM werden digitale Signale, welche zur Basisstation BSM gesendet werden sollen, der Sendeeinrichtung SEM zugeführt, wobei sie in dieser zunächst von einem Digital-Analog-Wandler DAM in analoge Signale bzw. in Signalanteile I und Q umgewandelt werden, welche schließlich einem Sendebauteil TXM zugeführt werden. Im Sendebauteil TXM werden Signale moduliert und schließlich einem Leistungsverstärker PA zugeführt, so dass sie mit angemessener Leistung über den Antennenschalter AS und die Antenne ANTM als Funksignale FST zur Basisstation BSM gesendet werden können.

Es sei nun auf Figur 3 verwiesen, in der eine zeitliche Struktur des Abstrahlens von Rundfunksignalen (DVB-H-Bursts; niedrige breite Bursts) seitens der Rundfunkstation BSD, sowie das Senden von Funksignalen FST (GSM-Bursts; hohe schmale Bursts) seitens des Mobiltelefons veranschaulicht ist. Die DVB-H-Bursts treten dabei in ersten Zeitabschnitten ZA1 auf, deren Zeitdauer für den ersten der vier ersten Zeitabschnitte in der Figur veranschaulicht ist. Die Zeitdauer der Zeitabschnitte ZA1 kann unterschiedlich lang sein. Zwischen den ersten Zeitabschnitten ZA1 gibt es erste Zwischenzeitabschnitte ZZA1, in denen keine DVB-H-Burst auftreten. Wie es später ausführlicher erläutert werden wird, findet eine Messung des Rauschens, das durch das Senden von Funksignalen durch die Sendeeinrichtung SEM verursacht wird, vorzugsweise in den ersten Zwischenzeitabschnitten ZZA1 statt. Dabei ist zu bemerken, dass nicht nur die ersten Zeitabschnitte ZA1, sondern auch die ersten Zwischenzeitabschnitte ZZA1 zwischen den einzelnen DVB-H-Bursts unterschiedlich lang sein können, wobei in einem DVB-H-Burst angegeben wird, wann ein folgender DVB-H-Burst wieder zu erwarten ist. Es sei dabei bemerkt, dass es sich bei den DVB-H-Bursts um solche eines bestimmten DVB-H-Dienstes handelt, der gemäß dem DVB-H-Standard in einzelnen Zeitabschnitten bzw. Zeitschlitzen übertragen wird.

Des Weiteren sind in der Figur 3 GSM-Bursts gezeigt, die in zweiten Zeitabschnitten ZA2 mit stets gleicher Länge und stets gleichem Abstand zum nächsten Burst auftreten. Ferner ist in der Figur zu erkennen, dass aufgrund der unterschiedlichen Dauer der ersten Zeitabschnitte ZA1, sowie der unterschiedlich langen Pausen zwischen den DVB-H-Bursts (unterschiedlich langen ersten Zwischenzeitabschnitten), es zumindest teilweise zu einer Überlappung von DVB-H-Bursts und GSM-Bursts kommt. Gerade während dieser Überlappungen kommt es dann zu Störungen beim Empfang der Rundfunksignale RFS.

In den folgenden Figuren 4 bis 7 sollen nun schaltungstechnische Möglichkeiten aufgezeigt werden, wie der Empfang von Rundfunksignalen optimiert bzw. eine Zerstörung der Empfängerkette EK des Funkmoduls FMD vermieden werden kann.

Es sei zunächst auf Figur 4 verwiesen, in der eine erste bevorzugte Ausführungsform der Erfindung zur Verbesserung des Empfangs von Rundfunksignalen und zur Verhinderung der Zerstörung der Empfängerkette bzw. Komponenten hiervon gezeigt ist. Genauer gesagt ist in Figur 4 ein Ausschnitt einer Empfängerkette gezeigt, die in dem in Figur 2 gezeigte Funkmodul FMD zum Empfangen und Verarbeiten von Rundfunksignalen verwendet werden kann. Dabei entspricht die in Figur 4 gezeigte Empfängerkette EK1 im Wesentlichen der Empfängerkette EK bzw. dem entsprechenden Ausschnitt hiervon von Figur 2. So hat die Empfängerkette EK1 eine Antenne ANTD zum Empfangen von Rundfunksignalen, insbesondere digitalen Rundfunksignalen, wie Fernsehsignalen gemäß dem DVB-H-Standard. Die empfangenen Rundfunksignale laufen dann in ein Bandpassfilter BPF und von dort in einen Eingangsverstärker bzw. rauscharmen Verstärker LNA. Ein durch den Verstärker LNA verstärktes Signal wird dann einem Empfängerbauteil RXD zugeleitet. Das Empfängerbauteil RXD umfasst, wie es im vorliegenden Fall beispielhaft gezeigt ist, ein erstes Bandpassfilter BPF1 zum Durchlassen eines spezifischen Frequenzbands, einen nachgeschalteten Mischer MI, der mit einem lokalen Oszillator LO verbunden ist, sowie ein nachgeschaltetes zweites Bandpassfilter BPF2 zum Durchlassen eines zweiten Frequenzbands, und schließlich einen zweiten Verstärker RA zum Verstärken eines Signals, das das zweite Bandpassfilter BPF2 durchlaufen hat. Ein Signal, das das Empfängerbauteil RXD passiert hat, kann dann, wie es in Figur 2 bezüglich der Empfängerkette EK gezeigt ist, (aufgespalten in Signalanteile I.und Q) einem Analog-Digital-Wandler ADD bzw. von dort einem Prozessor PRD zugeführt werden.

Kennzeichen der Empfängerkette EK1 ist, dass der rauscharme Verstärker LNA bezüglich seiner Leistung bzw. Verstärkung VS durch die Steuereinrichtung STE einstellbar ist. Daneben ist auch gemäß dem Beispiel von Figur 4 der Verstärker RA bezüglich seiner Verstärkung einstellbar.

Im Folgenden soll nun die Funktionsweise der in Figur 4 gezeigten Schaltung zum Optimieren des Empfangs von Rundfunksignalen erläutert werden. Es sei dabei auf Figur 3 verwiesen, in der, wie oben erwähnt, die zeitliche Struktur des Abstrahlens von Rundfunksignalen seitens der Rundfunkstation BSD in den ersten Zeitabschnitten ZA1, sowie das Senden von Funksignalen FST seitens der Sendeeinrichtung SEM des Mobiltelefons MFG veranschaulicht ist. Um nun eine möglichst hohe Empfindlichkeit zum Empfangen der Rundfunksignale erreichen zu können, ohne eine Zerstörung der Empfängerkette EK1 zu riskieren, ist es vorteilhaft, beispielsweise vor dem ersten ersten Zeitabschnitt ZA1 eine Messung des von der Empfängerkette EK1 durch das Senden von Funksignalen seitens der Sendeeinrichtung SEM wahrgenommenen Rauschens zu messen. Es ist auch ein Messen des Rauschens in den ersten Zwischenzeitabschnitten ZZA1 möglich. In den Zeiten, wie den ersten Zwischenzeitabschnitten sollen von dem Funkmodul FMD keine Rundfunksignale empfangen werden, so dass es für die Messung des Rauschens seitens der Sendeeinrichtung vorteilhaft ist, die Verstärkung VS auf einem (maximal möglichen) Wert einzustellen, bei dem gerade keine Zerstörung des Empfängerbauteils RXD möglich ist. Es sei bemerkt, dass es nicht vorteilhaft ist, die Verstärkung zu niedrig einzustellen, da sonst die Messung der oben genannten Rauschparameter ungenügend gut sein könnte. Nach dem "Unempfindlich"-Einstellen der Verstärkung VS des Verstärkers LNA wird nun ein GSM-Burst während eines zweiten Zeitabschnitts ZA2 von der Sendeeinrichtung SEM erzeugt. Parallel dazu wird das durch den GSM-Burst erzeugte Rauschen in der Empfängerkette EK1 gemessen bzw. ermittelt. Insbesondere wird (für die Schaltung nach Figur 4) der Pegel des Rauschens verursacht durch den GSM-Burst ermittelt. Wie bereits oben erwähnt, kann der Rauschpegel von einer dem in Figur 4 gezeigten Empfängerbauteil RXD nachgeschalteten Prozessor PRD an die Steuereinrichtung STE weitergeleitet werden. Nun kann die Steuereinrichtung STE in Abhängigkeit des gemessenen bzw. ermittelten Rauschpegels den Verstärker LNA derart ansteuern, dass dessen Verstärkung VS auf einen Wert eingestellt wird, der eine maximale Empfindlichkeit zum Empfangen von Rundfunksignalen bietet, aber jedoch nicht einen maximalen Signalpegel übersteigt, der am Empfängerbauteil RXD anliegen darf, ohne es zu zerstören. Entsprechend kann auch die Verstärkung des Verstärkers RA zur Verbesserung des Empfangs bzw. zur Verringerung von Störungen beim Empfang von Rundfunksignalen eingestellt werden.

Es ist vorteilhaft, die zuvor beschriebene Messung des Rauschens einmal oder mehrmals oder auch in regelmäßigen Zeitabständen zu wiederholen, insbesondere jedoch bei einem Wechsel der Sendefrequenz der Sendeeinrichtung bzw. einer Empfangsfrequenz der Empfängerkette zum Empfangen von Rundfunksignalen, oder aber auch bei einer Änderung der Sendeleistung der Sendeeinrichtung. Dabei kann die durch das Rauschen der Sendeeinrichtung verursachte Störung über einen oder mehrere gemessene GSM-Bursts gemittelt werden.

Es sei nun auf Figur 5 verwiesen, in der eine zweite Ausführungsform zur Verbesserung des Empfangs von Rundfunksignalen gezeigt ist. Die in Figur 5 gezeigte Empfängerkette EK2 entspricht dabei im Wesentlichen der in Figur 4 gezeigten Empfängerkette EK1, weshalb für eine ausführliche Erläuterung auf die Erläuterung zu Figur 4 oder auf Figur 2 verwiesen wird.

Kennzeichen der zweiten Ausführungsform ist es, dass neben in der Verstärkung VS einstellbaren Verstärkern LNA und RA auch bezüglich des Empfangsfrequenzbands veränderbare Bandpassfilter BPF und BPF1 vorgesehen sind. Entsprechend dem in Figur 4 dargestellten Verfahren zur Optimierung der Einstellungen der Empfängerkette zum Empfangen von Rundfunksignalen wird vor dem Empfang eines Rundfunksignals bzw. in den ersten Zwischenzeitabschnitten ZZA1 eine Messung des durch die Sendeeinrichtung SEM verursachten Rauschens gemessen bzw. ermittelt. Wie bereits zu Figur 4 erwähnt, ist es vorteilhaft, nicht nur den Rauschpegel, sondern auch die spektralen Eigenschaften des Rauschens zu ermitteln. Deshalb wird zu einer Zeit, zu der kein Rundfunksignal erwartet wird, die Empfängerkette bzw. der rauscharme Verstärker LNA oder auch der Verstärker RA unempfindlich geschaltet, um eine Zerstörung der Empfängerkette bzw. Komponenten hiervon zu vermeiden. Nun wird von der Sendeeinrichtung SEM während eines zweiten Zeitabschnitts ZA2 ein GSM-Sendeburst erzeugt. Das durch diesen wahrgenommene Rauschen wird von der Empfängerkette EK2 nun gemessen bzw. ermittelt. Anhand des gemessenen Rauschpegels können nun die Verstärker LNA bzw. RA, wie bezüglich Figur 4 erläutert, eingestellt werden. Ferner kann anhand des gemessenen Rauschspektrums nun auch der Durchlassbereich des Filters BPF und/oder des Filters BPF1 derart eingestellt werden, dass der Einfluss des Rauschens seitens der Sendeeinrichtung SEM auf den Empfang von Rundfunksignalen durch die Empfängerkette EK2 minimiert wird. Befinden sich beispielsweise im Rauschspektrum spektrale Maxima, wie beispielsweise Spuren, so kann das Filter BPF und/oder das Filter BPF1 derart eingestellt werden, dass beispielsweise derartige spektrale Maxima nicht mehr durch ein jeweiliges Filter durchgelassen werden. Somit wird der Empfang der Rundfunksignale verbessert und eine Störung bzw. Zerstörung durch Funksignale bzw. Sendebursts seitens der Sendeeinrichtung SEM minimiert.

Es sei nun auf Figur 6 verwiesen, in der eine dritte Ausführungsform zur Optimierung der Einstellungen der Empfängerkette zum Empfangen von Rundfunksignalen gezeigt ist. Dabei entspricht die in Figur 6 gezeigte Empfängerkette EK3 im Wesentlichen der in Figur 5 gezeigten Empfängerkette EK2, weshalb für eine ausführliche Erläuterung der jeweiligen dargestellten Komponenten auf eine der vorhergehenden Figuren verwiesen wird.

Das Kennzeichen der dritten Ausführungsform nach Figur 6 besteht darin, dass zusätzlich zu einstellbaren Filtern und Verstärkern auch noch die Antenneneinstellung der Antenne ANTD veränderbar ist. Wie bezüglich Figur 5 erläutert, wird zu einer Zeit, zu der kein Rundfunksignal erwartet wird (vor einem ersten Zeitabschnitt oder in einem jeweiligen ersten Zwischenzeitabschnitt), die Empfängerkette bzw. der rauscharme Verstärker LNA oder auch der Verstärker RA unempfindlich geschaltet, um eine Zerstörung der Empfängerkette bzw. Komponenten hiervon zu vermeiden. Nun wird von der Sendeeinrichtung SEM während eines zweiten Zeitabschnitts ZA2 ein GSM-Sendeburst erzeugt. Das durch diesen wahrgenommene Rauschen wird von der Empfängerkette EK2 nun gemessen bzw. ermittelt. Anhand des gemessenen Rauschpegels können nun die Verstärker LNA bzw. RA, wie bezüglich Figur 4 erläutert, eingestellt werden. Ferner kann, wie bezüglich Figur 5 erläutert, anhand des gemessenen Rauschspektrums auch der Durchlassbereich der Filter BPF und BPF1 derart eingestellt werden, dass der Einfluss des Rauschens seitens der Sendeeinrichtung SEM auf den Empfang von Rundfunksignalen durch die Empfängerkette EK2 minimiert wird. Wie bei der Einstellung des Empfangsfrequenzbands durch einen der Filter BPF bzw. BPF1 nach Figur 5 ist es hier bezüglich der dritten Ausführungsform ferner möglich, den Empfangsbereich der insbesondere schmalbandigen Antenne ANTD zu variieren. Beispielsweise kann der Empfangsbereich bzw. das Empfangsfrequenzband der abstimmbaren Antenne derart eingestellt werden, dass eine maximale Empfindlichkeit für den Empfang von Rundfunksignalen bei minimaler Störung durch einen GSM-Burst gegeben ist. Insbesondere kann der Empfangsbereich der abstimmbaren Antenne ANTD derart gewählt werden, um spektrale Maxima des Rauschens nicht zu empfangen bzw. zu beseitigen. Es sei noch bemerkt, dass die Ausführungsform von Figur 6 auch derart abgewandelt werden kann, dass lediglich die Antenne ANTD in ihrem Durchlassbereich einstellbar ist, nicht jedoch die Bandpassfilter BPF bzw. BPF1.

Zum Erreichen einer geeigneten Antenneneinstellung ist es dabei auch möglich, wiederholt Messungen durchzuführen, wobei während einer Messreihe verschiedene Antenneneinstellungen geprüft werden können, und diejenige Einstellung, welche die geringste Störung in der Empfängerkette mit sich bringt, schließlich für den Empfang von Rundfunksignalen gewählt wird.

Es sei nun auf Figur 7 verwiesen, in der eine bevorzugte Ausführungsform des Funkabschnitts des Funkmoduls FMM zur Verbesserung des Empfangs von Rundfunksignalen gezeigt ist. Dabei entspricht das Funkmodul FMM' im Wesentlichen dem Funkmodul FMM von Figur 2, weshalb für eine ausführliche Erläuterung gleicher Komponenten auf die Erläuterung von Figur 2 verwiesen wird. Die aus Figur 2 bekannte Komponenten, wie die Antenne ANTM, der Antennenschalter AS, die Empfangseinrichtung EEM sind lediglich schematisch dargestellt. Kennzeichen der Ausführungsform nach Figur 7 ist, dass zwischen dem Antennenschalter AS und dem Leistungsverstärker PA der Sendeeinrichtung SEM (aus Gründen der Übersichtlichkeit sind die dem Leistungsverstärker PA vorgeschalteten Komponenten nicht dargestellt) ein Schalter SCH sowie ein diesem nachgeschaltetes Filter FI mit einem vorbestimmten Frequenzdurchlassbereich, wie beispielsweise ein Bandpassfilter BPF, Hochpassfilter, Tiefpassfilter oder Notch-Filter vorgesehen sind. Durch eine entsprechende Schalterstellung des Schalters SCH (in der Figur bei einer Schalterstellung nach unten) ist es möglich, dass das in der Sendeeinrichtung SEM erzeugte Sendesignal entweder ohne Einschränkung über den ersten Signalweg SW1 zum Antennenschalter AS und von diesem zur Antenne ANTM gelangt oder bei einer zweiten Schalterstellung (in der Figur bei einer Schalterstellung nach oben), wie sie in Figur 7 gezeigt ist, das Sendesignal über einen zweiten Signalweg SW2 das Filter FI passieren muss, um schließlich erst dann über den Antennenschalter AS zur Antenne ANTM zu gelangen.

Um nun die Sendeeinrichtung gemäß Figur 7 für den best möglichen Empfang von Rundfunksignalen zu optimieren, kann wie folgt vorgegangen werden. Zunächst wird der Schalter SCH in eine erste Stellung gebracht, bei der das von dem Leistungsverstärker PA kommende Sendesignal über den ersten Sendeweg SW1 geleitet wird. Anschließend wird wie bezüglich der Figuren 4 bis 6 erläutert, vorteilhafter Weise zu Zeiten, in denen keine Rundfunksignale empfangen werden (beispielsweise in den ersten Zwischenzeitabschnitten) das Rauschen in der Empfängerkette des Funkmoduls FMD gemessen, das durch einen durch die Sendeeinrichtung SEM erzeugten GSM-Burst verursacht wird. Dabei kann zum Einen der Rauschpegel oder auch das Rauschspektrum gemessen werden. Stellt sich heraus, dass der Empfang von Rundfunksignalen bei einem gleichzeitigen Betrieb der Sendeeinrichtung durch das von dieser verursachte Rauschen zu sehr beeinträchtigt wird, beispielsweise weil der Rauschpegel zu hoch ist, so kann diesem Problem dahingehend abgeholfen werden, dass bei einer aktivierten Empfängerkette (während eines ersten Zeitabschnitts) der Schalter SCH von der ersten in die zweite Stellung gebracht wird, bei dem das Sendesignal durch das Filter FI geleitet wird, um das sendeseitige Rauschen einzuschränken, insbesondere den Rauschpegel im Empfangsfrequenzband der Empfängerkette zu minimieren.

Es ist dabei möglich, dass die Messung bzw. Ermittlung des verursachten Rauschens ohne Zwischenschaltung des Filters FI einmalig durchgeführt wird oder zu bestimmten Zeitpunkten wiederholt wird. Stellt sich insbesondere bei jeder Messung des Rauschens ohne zwischengeschaltetes Filter FI heraus, dass die Beeinflussung des Rauschens durch einen GSM-Burst auf die Empfängerkette des Funkmoduls FMD zu hoch ist, so kann die Sendeeinrichtung SEM von Haus aus derart eingestellt werden, dass bei gleichzeitigem Betrieb der Empfängerkette des Funkmoduls FMD und der Sendeeinrichtung SEM des Funkmoduls FMM (d. h. wenn die ersten und die zweiten Zeitabschnitte überlappen), der Schalter SCH in die zweite Stellung gebracht wird, um das Filter FI in den Sendesignalweg zu schaltet, während bei nicht aktiver Empfängerkette (in den ersten Zwischenzeitabschnitten) der Schalter SCH in die erste Stellung gebracht wird.

Es sei abschließend erwähnt, dass einzelnen in den Figuren 4 bis 6 gezeigten Ausführungsformen auch mit der in Figur 7 gezeigten Ausführungsform kombiniert werden können, um ein Kommunikationsendgerät mit Funkmodulen FMD und FMM zu schaffen, die einen optimierten Empfang von Rundfunksignalen gewährleisten.

## Patentansprüche

1. Verfahren zum Betreiben eines Kommunikationsendgeräts (MFG) umfassend
- eine Empfängerkette (EK, EK1, EK2, EK3; LNA, RXD) mit zumindest einem Empfängerbauteil (RXD) und einer diesem vorgeschalteten Verstärkereinrichtung (LNA) zum Empfangen von in ersten Zeitabschnitten (ZA1) gesendeten Rundfunksignalen (RFS) in einem vorbestimmten Frequenzband (EFB);
- eine Sendeeinrichtung (SEM) zum Senden von Funksignalen (FST);
wobei das Verfahren folgende Schritte aufweist:
- Messen des beim Senden der Funksignale in dem Frequenzband der Empfängerkette auftretenden Rauschens in der Empfängerkette;
- Einstellen der Verstärkung (VS) der Verstärkereinrichtung in Abhängigkeit des gemessenen Rauschens derart, dass ein maximaler an dem Empfängerbauteil anliegender Signalpegel nicht überschritten wird.

2. Verfahren nach Anspruch 1,
bei dem das Messen des Rauschens in der Empfängerkette (EK, EK1, EK2, EK3) in ersten Zwischenzeitabschnitten (ZZA1) stattfindet, welche zwischen den ersten Zeitabschnitten (ZA1) liegen.

3. Verfahren nach Anspruch 1 oder 2,
bei dem die Sendeeinrichtung (SEM) die Funksignale (FST) in zweiten Zeitabschnitten (ZA2) sendet, welche zumindest teilweise mit den ersten Zeitabschnitten (ZA1) überlappen.

4. Verfahren nach einem der Ansprüche 1 bis 3,
bei dem das Messen des Rauschens in der Empfängerkette wiederholt durchgeführt wird.

5. Verfahren nach Anspruch 4,
bei dem das Messen des Rauschens in regelmäßigen Zeitabständen durchgeführt wird.

6. Verfahren nach einem der Ansprüche 1 bis 5,
bei dem die Sendeeinrichtung (SEM) in der Lage ist, die Sendefrequenz, auf der sie Funksignale sendet, zu variieren, wobei das Messen des Rauschens dann durchgeführt wird, nachdem die Sendeeinrichtung (SEM) die Sendefrequenz geändert hat.

7. Verfahren nach einem der Ansprüche 1 bis 6,
bei dem die Sendeeinrichtung (SEM) in der Lage ist, die Sendeleistung, mit der sie die Funksignale sendet, zu variieren, wobei das Messen des Rauschens dann durchgeführt wird, nachdem die Sendeeinrichtung die Sendeleistung geändert hat.

8. Verfahren nach einem der Ansprüche 4 bis 7,
bei dem die Empfängerkette (EK2, EK3) in der Lage ist, die Empfangsfrequenz, auf der bestimmte Rundfunksignale empfangen werden, innerhalb des Frequenzbands zu variieren, wobei das Messen des Rauschens dann durchgeführt wird, nachdem die Empfängerkette die Empfangsfrequenz geändert hat.

9. Verfahren nach einem der Ansprüche 1 bis 8,
bei dem vor dem Durchführen des Messens des Rauschens die Verstärkung (VS) der Verstärkereinrichtung (LNA) auf einen maximal möglichen Wert eingestellt wird, bei dem keine Zerstörung des Empfängerbauteils (RXD) während der Messung des Rauschens eintritt.

10. Verfahren nach einem der Ansprüche 1 bis 9,
bei dem die Empfängerkette ferner ein einstellbares Bandpassfilter (BPF) zum Durchlassen eines gewünschten Frequenzbands aufweist, wobei das Bandpassfilter in Abhängigkeit des gemessenen Rauschens derart bezüglich des Frequenzbands eingestellt wird, dass das durch das Senden der Funksignale verursachte Rauschen in der Empfängerkette minimiert wird.

11. Verfahren nach einem der Ansprüche 1 bis 10,
bei dem die Empfängerkette (EK3) ferner eine abstimmbare Antenne (ANTD) zum Empfangen eines gewünschten Frequenzbands aufweist, wobei die Antenne in Abhängigkeit des gemessenen Rauschens derart bezüglich des Frequenzbands eingestellt wird, dass das durch das Senden der Funksignale verursachte Rauschen in der Empfängerkette minimiert wird.

12. Verfahren nach einem der Ansprüche 1 bis 11,
bei dem bei dem Messen des Rauschens die spektralen Eigenschaften des Rauschens ermittelt werden, wobei die Linearität der Verstärkereinrichtung (LNA) in Abhängigkeit von ermittelten spektralen Maxima eingestellt wird.

13. Verfahren nach einem der Ansprüche 1 bis 12,
bei dem die Sendeeinrichtung (SEM) ferner ein zuschaltbares sendeseitiges Frequenzfilter (FI) aufweist, das in Abhängigkeit des gemessenen Rauschens in den Sendepfad der Sendeeinrichtung zugeschaltet wird, so dass das durch das Senden der Funksignale (FST) verursachte Rauschen in der Empfängerkette minimiert wird.

14. Kommunikationsendgerät (MFG), insbesondere zum Durchführen eines Verfahrens nach einem der vorhergehenden Ansprüche, mit folgenden Merkmalen:
- einer Empfängerkette (EK, EK1, EK2, EK3; LNA, RXD) umfassend zumindest ein Empfängerbauteil (RXD) und eine diesem vorgeschaltete Verstärkereinrichtung (LNA) zum Empfangen von in ersten Zeitabschnitten (ZA1) gesendeten Rundfunksignalen (RFS) in einem vorbestimmte Frequenzband (EFB);
- einer Sendeeinrichtung (SEM) zum Senden von Funksignalen (FST);
- einer Steuereinrichtung (STE), die mit der Empfängerkette verbunden ist und dafür eingerichtet ist:
- das beim Senden der Funksignale (FST) in dem Frequenzband auftretende Rauschen in der Empfängerkette zu ermitteln; und
- die Verstärkung (VS) der Verstärkereinrichtung (LNA) in Abhängigkeit des ermittelten Rauschens derart einzustellen, dass ein maximaler an dem Empfängerbauteil anliegender Signalpegel nicht überschritten wird.

15. Kommunikationsendgerät nach Anspruch 14,
bei dem die Steuereinrichtung (STE) derart eingerichtet ist, das Ermitteln des Rauschens in der Empfängerkette in ersten Zwischenzeitabschnitten (ZZA1) durchzuführen, welche zwischen den ersten Zeitabschnitten (ZA1) liegen.

16. Kommunikationsendgerät nach Anspruch 14 oder 15,
bei dem die Sendeeinrichtung (SEM) die Funksignale (FST) in zweiten Zeitabschnitten sendet, welche zumindest teilweise mit den ersten Zeitabschnitten überlappen.

17. Kommunikationsendgerät nach einem der Ansprüche 14 bis 16,
bei dem die Steuereinrichtung (STE) derart eingerichtet ist, das Ermitteln des Rauschens in der Empfängerkette wiederholt durchzuführen.

18. Kommunikationsendgerät nach Anspruch 17,
bei dem Steuereinrichtung (STE) derart eingerichtet ist, das Ermitteln des Rauschens in regelmäßigen Zeitabständen durchzuführen.

19. Kommunikationsendgerät nach einem der Ansprüche 14 bis 18,
bei dem die Sendeeinrichtung (SEM) in der Lage ist, die Sendefrequenz, auf der sie Funksignale sendet, zu variieren, wobei die Steuereinrichtung das Ermitteln des Rauschens dann durchführt, nachdem die Sendeeinrichtung die Sendeleistung geändert hat.

20. Kommunikationsendgerät nach einem der Ansprüche 14 bis 19,
bei dem die Sendeeinrichtung (SEM) in der Lage ist, die Sendeleistung, mit der sie die Funksignale sendet, zu variieren, wobei die Steuereinrichtung (STE) das Ermitteln des Rauschens dann durchführt, nachdem die Sendeeinrichtung die Sendeleistung geändert hat.

21. Kommunikationsendgerät nach einem der Ansprüche 14 bis 20,
bei dem die Empfängerkette in der Lage ist, die Empfangsfrequenz, auf der ein bestimmter Rundfunkdienst empfangen wird, innerhalb des Frequenzbands zu variieren, wobei die Steuereinrichtung (STE) das Ermitteln des Rauschens dann durchführt, nachdem die Empfängerkette die Empfangsfrequenz geändert hat.

22. Kommunikationsendgerät nach einem der Ansprüche 14 bis 21,
bei dem die Steuereinrichtung vor dem Durchführen des Ermittelns des Rauschens die Verstärkung (VS) der Verstärkereinrichtung auf einen maximal möglichen Wert einstellt, bei dem keine Zerstörung des Empfängerbauteils während der Messung eintritt.

23. Kommunikationsendgerät nach einem der Ansprüche 14 bis 22,
bei dem die Empfängerkette ferner ein einstellbares Bandpassfilter (BPF) zum Durchlassen eines gewünschten Frequenzbands aufweist, wobei die Steuereinrichtung (STE) das Bandpassfilter in Abhängigkeit des gemessenen Rauschens derart bezüglich des Frequenzbands einstellt, dass das durch das Senden der Funksignale verursachte Rauschen in der Empfängerkette minimiert wird.

24. Kommunikationsendgerät nach einem der Ansprüche 14 bis 23,
bei dem die Empfängerkette (EK3) ferner eine abstimmbare Antenne (ANTD) zum Empfangen eines gewünschten Frequenzbands aufweist, wobei die Steuereinrichtung (STE) die Antenne in Abhängigkeit des gemessenen Rauschens derart bezüglich des Frequenzbands einstellt, dass das durch das Senden der Funksignale verursachte Rauschen in der Empfängerkette minimiert wird.

25. Kommunikationsendgerät nach einem der Ansprüche 14 bis 24,
bei dem bei dem Ermitteln des Rauschens ferner die spektralen Eigenschaften des Rauschens ermittelt werden, wobei die Steuereinrichtung die Linearität der Verstärkereinrichtung in Abhängigkeit von ermittelten spektralen Maximal einstellt.

26. Kommunikationsendgerät nach einem der Ansprüche 14 bis 25,
bei dem die Sendeeinrichtung (SEM) ferner ein zuschaltbares sendeseitiges Frequenzfilter (FI) aufweist, wobei die Steuereinrichtung (STE) das sendeseitige Frequenzfilter in Abhängigkeit des gemessenen Rauschens in den Sendepfad der Sendeeinrichtung zuschaltet, so dass das durch das Senden der Funksignale (FST) verursachte Rauschen in der Empfängerkette minimiert wird.

27. Kommunikationsendgerät nach einem der Ansprüche 14 bis 26,
das als ein tragbares Gerät ausgebildet ist.

28. Kommunikationsendgerät nach Anspruch 27,
das als ein Mobilfunkgerät, ein Mobiltelefon (MFG) oder ein tragbarer Computer mit Funkmodul ausgebildet ist.

## Claims

1. Method for operating a communication terminal (MFG) comprising
- a receiver chain (EK, EK1, EK2, EK3; LNA, RXD) having at least one receiver component (RXD) and an amplifier device (LNA) connected upstream therefrom for receiving broadcast radio signals (RFS) transmitted in first time periods (ZA1) in a predefined frequency band (EFB);
- a transmission device (SEM) for transmitting radio signals (FST);
wherein the method has the following steps:
- measuring the noise in the receiver chain which occurs upon transmission of the radio signals in the frequency band of the receiver chain;
- setting the gain (VS) of the amplifier device as a function of the measured noise in such a way that a maximum signal level present at the receiver component is not exceeded.

2. Method according to Claim 1,
wherein the measurement of the noise in the receiver chain (EK, EK1, EK2, EK3) takes place in first intermediate time periods (ZZA1) present between the first time periods (ZA1).

3. Method according to Claim 1 or 2,
wherein the transmission device (SEM) transmits the radio signals (FST) in second time periods (ZA2) which at least partially overlap with the first time periods (ZA1).

4. Method according to one of Claims 1 through 3,
wherein the measurement of the noise in the receiver chain is carried out repeatedly.

5. Method according to Claim 4,
wherein the measurement of the noise is carried out at regular time intervals.

6. Method according to one of Claims 1 through 5,
wherein the transmission device (SEM) is able to vary the transmission frequency at which it transmits radio signals, the measurement of the noise being carried out after the transmission device (SEM) has changed the transmission frequency.

7. Method according to one of Claims 1 through 6,
wherein the transmission device (SEM) is able to vary the transmission power with which it transmits the radio signals, the measurement of the noise being carried out after the transmission device has changed the transmission power.

8. Method according to one of Claims 4 through 7,
wherein the receiver chain (EK2, EK3) is able to vary within the frequency band the receiving frequency at which specific broadcast radio signals are received, the measurement of the noise being carried out after the receiver chain has changed the receiving frequency.

9. Method according to one of Claims 1 through 8,
wherein before the measurement of the noise is carried out, the gain (VS) of the amplifier device (LNA) is set to a maximum possible value at which no destruction of the receiver component (RXD) occurs during the measurement of the noise.

10. Method according to one of Claims 1 through 9,
wherein the receiver chain also has an adjustable band pass filter (BPF) for admitting a desired frequency band, the band pass filter being set with respect to the frequency band as a function of the measured noise in such a way that the noise in the receiver chain caused by the transmission of the radio signals is minimized.

11. Method according to one of Claims 1 through 10,
wherein the receiver chain (EK3) also has a tunable antenna (ANTD) for receiving a desired frequency band, the antenna being adjusted with respect to the frequency band as a function of the measured noise in such a way that the noise in the receiver chain caused by the transmission of the radio signals is minimized.

12. Method according to one of Claims 1 through 11,
wherein the spectral properties of the noise are ascertained during the measurement of the noise, the linearity of the amplifier device (LNA) being set as a function of ascertained spectral maxima.

13. Method according to one of Claims 1 through 12,
wherein the transmission device (SEM) also has a connectable transmission-side frequency filter (FI) which is connected to the transmission path of the transmission device as a function of the measured noise, so that the noise in the receiver chain caused by the transmission of the radio signals (FST) is minimized.

14. Communication terminal (MFG), in particular for carrying out a method according to one of the preceding claims, having the following features:
- a receiver chain (EK, EK1, EK2, EK3; LNA, RXD) comprising at least one receiver component (RXD) and an amplifier device (LNA) connected upstream therefrom for receiving broadcast radio signals (RFS) transmitted in first time periods (ZA1) in a predefined frequency band (EFB);
- a transmission device (SEM) for transmitting radio signals (FST);
- a control unit (STE) which is connected to the receiver chain and is configured:
- to determine the noise in the receiver chain which occurs upon transmission of the radio signals (FST) in the frequency band; and
- to set the gain (VS) of the amplifier device (LNA) as a function of the determined noise in such a way that a maximum signal level present at the receiver component is not exceeded.

15. Communication terminal according to Claim 14,
wherein the control unit (STE) is configured to determine the noise in the receiver chain in first intermediate time periods (ZZA1) present between the first time periods (ZA1).

16. Communication terminal according to Claim 14 or 15,
wherein the transmission device (SEM) transmits the radio signals (FST) in second time periods which at least partially overlap with the first time periods.

17. Communication terminal according to one of Claims 14 through 16,
wherein the control unit (STE) is configured to repeatedly determine the noise in the receiver chain.

18. Communication terminal according to Claim 17,
wherein the control unit (STE) is configured to determine the noise at regular time intervals.

19. Communication terminal according to one of Claims 14 through 18,
wherein the transmission device (SEM) is able to vary the transmission frequency at which it transmits radio signals, the control unit determining the noise after the transmission device has changed the transmission power.

20. Communication terminal according to one of Claims 14 through 19,
wherein the transmission device (SEM) is able to vary the transmission power with which it transmits the radio signals, the control unit (STE) determining the noise after the transmission device has changed the transmission power.

21. Communication terminal according to one of Claims 14 through 20,
wherein the receiver chain is able to vary within the frequency band the receiving frequency at which a specific broadcast radio service is received, the control unit (STE) determining the noise after the receiver chain has changed the receiving frequency.

22. Communication terminal according to one of Claims 14 through 21,
wherein before the measurement of the noise is carried out, the control unit sets the gain (VS) of the amplifier device to a maximum possible value at which no destruction of the receiver component occurs during the measurement.

23. Communication terminal according to one of Claims 14 through 22,
wherein the receiver chain also has an adjustable band pass filter (BPF) for admitting a desired frequency band, the control unit (STE) setting the band pass filter with respect to the frequency band as a function of the measured noise in such a way that the noise in the receiver chain caused by the transmission of the radio signals is minimized.

24. Communication terminal according to one of Claims 14 through 23,
wherein the receiver chain (EK3) also has a tunable antenna (ANTD) for receiving a desired frequency band, the control unit (STE) adjusting the antenna with respect to the frequency band as a function of the measured noise in such a way that the noise in the receiver chain caused by the transmission of the radio signals is minimized.

25. Communication terminal according to one of Claims 14 through 24,
wherein the spectral properties of the noise are also ascertained during the determination of the noise, the control unit setting the linearity of the amplifier device as a function of ascertained spectral maxima.

26. Communication terminal according to one of Claims 14 through 25,
wherein the transmission device (SEM) also has a connectable transmission-side frequency filter (FI), the control unit connecting the transmission-side frequency filter to the transmission path of the transmission device as a function of the measured noise, so that the noise in the receiver chain caused by the transmission of the radio signals (FST) is minimized.

27. Communication terminal according to one of Claims 14 through 26,
which is designed as a portable device.

28. Communication terminal according to Claim 27,
designed as a mobile wireless device, a mobile telephone (MFG), or a portable computer having a radio module.

## Revendications

1. Procédé de fonctionnement d'un terminal de communication (MFG) comprenant :
- une chaîne de réception (EK, EK1, EK2, EK3 ; LNA, RXD) avec au moins un composant récepteur (RXD) et un dispositif amplificateur (LNA) placé en amont de celui-ci, destinée à recevoir des signaux radio (RFS) émis dans des premiers intervalles de temps (ZA1) sur une bande de fréquences prédéterminée (EFB) ;
- un dispositif émetteur (SEM) destiné à émettre des signaux radio (FST) ;
le procédé comprenant les étapes suivantes consistant à :
- mesurer le bruit présent sur la chaîne de réception lors de l'émission des signaux radio sur la bande de fréquences de la chaîne de réception ;
- régler l'amplification (VS) du dispositif amplificateur en fonction du bruit mesuré, de manière à ne pas dépasser un niveau de signal maximal injecté au composant récepteur.

2. Procédé selon la revendication 1, dans lequel la mesure du bruit sur la chaîne de réception (EK, EK1, EK2, EK3) s'effectue dans des premiers intervalles de temps intermédiaires (ZZA1) qui se situent entre les premiers intervalles de temps (ZA1).

3. Procédé selon l'une des revendications 1 ou 2, dans lequel le dispositif émetteur (SEM) émet les signaux radio (FST) dans des deuxièmes intervalles de temps (ZA2) qui se superposent au moins partiellement avec les premiers intervalles de temps (ZA1).

4. Procédé selon l'une des revendications 1 à 3, dans lequel la mesure du bruit sur la chaîne de réception est exécutée répétitivement.

5. Procédé selon la revendication 4, dans lequel la mesure du bruit est exécutée à des intervalles réguliers dans le temps.

6. Procédé selon l'une des revendications 1 à 5, dans lequel le dispositif émetteur (SEM) est en mesure de faire varier la fréquence d'émission utilisée pour émettre les signaux radio, la mesure du bruit étant exécutée après que le dispositif émetteur (SEM) a modifié la fréquence d'émission.

7. Procédé selon l'une des revendications 1 à 6, dans lequel le dispositif émetteur (SEM) est en mesure de faire varier la puissance d'émission utilisée pour émettre les signaux radio, la mesure du bruit étant alors exécutée après que le dispositif émetteur a modifié la puissance d'émission.

8. Procédé selon l'une des revendications 4 à 7, dans lequel la chaîne de réception (EK2, EK3) est en mesure de faire varier dans la bande de fréquences la fréquence de réception sur laquelle sont reçus des signaux radio définis, la mesure du bruit étant alors exécutée après que la chaîne de réception a modifié la fréquence de réception.

9. Procédé selon l'une des revendications 1 à 8, dans lequel, avant d'exécuter la mesure du bruit, l'amplification (VS) du dispositif amplificateur (LNA) est réglée à une valeur maximale possible à laquelle il ne se produit pas de destruction du composant récepteur (RXD) pendant la mesure du bruit.

10. Procédé selon l'une des revendications 1 à 9, dans lequel la chaîne de réception comporte en outre un filtre passe-bande (BPF) réglable pour laisser passer une bande de fréquences souhaitée, le filtre passe-bande étant réglé en termes de bande de fréquences de telle manière que le bruit causé par l'émission des signaux radio soit rendu minimal sur la chaîne de réception.

11. Procédé selon l'une des revendications 1 à 10, dans lequel la chaîne de réception (EK3) comporte en outre une antenne accordable (ANTD) pour recevoir une bande de fréquences souhaitée, la bande de fréquences de l'antenne étant réglée en fonction du bruit mesuré de telle manière que le bruit causé par l'émission des signaux radio soit rendu minimal sur la chaîne de réception.

12. Procédé selon l'une des revendications 1 à 11, dans lequel les propriétés spectrales du bruit sont déterminées lors de la mesure du bruit, la linéarité du dispositif amplificateur (LNA) étant réglée en fonction des maxima spectraux déterminés.

13. Procédé selon l'une des revendications 1 à 12, dans lequel le dispositif d'émission (SEM) comprend en outre un filtre de fréquences d'émission (FI) commutable qui est placé sur le trajet d'émission du dispositif d'émission en fonction du bruit mesuré de manière que le bruit causé par l'émission des signaux radio (FST) sur la chaîne de réception soit rendu minimal.

14. Terminal de communication (MFG), en particulier destiné à mettre en oeuvre un procédé selon l'une des revendications précédentes, offrant les caractéristiques suivantes :
- une chaîne de réception (EK, EK1, EK2, EK3 ; LNA, RXD) comprenant au moins un composant récepteur (RXD) et un dispositif amplificateur (LNA) placé en amont de celui-ci, destinée à recevoir des signaux radio (RFS) émis dans des premiers intervalles de temps (ZA1) sur une bande de fréquences prédéterminée (EFB) ;
- un dispositif émetteur (SEM) destiné à émettre des signaux radio (FST) ;
- un dispositif de commande (STE) qui est relié à la chaîne de réception et qui est conçu pour :
- déterminer sur la chaîne de réception le bruit produit lors de l'émission des signaux radio (FST) sur la bande de fréquences ; et
- régler l'amplification (VS) du dispositif amplificateur (LNA) en fonction du bruit mesuré, de manière à ne pas dépasser un niveau de signal maximal injecté au composant récepteur.

15. Terminal de communication selon la revendication 14, dans lequel le dispositif de commande (STE) est conçu pour déterminer le bruit sur la chaîne de réception dans des premiers intervalles de temps intermédiaires (ZZA1) qui se situent entre les premiers intervalles de temps (ZA1).

16. Terminal de communication selon l'une des revendications 14 ou 15, dans lequel le dispositif émetteur (SEM) émet les signaux radio (FST) dans des deuxièmes intervalles de temps (ZA2) qui se superposent au moins partiellement avec les premiers intervalles de temps.

17. Terminal de communication selon l'une des revendications 14 à 16, dans lequel le dispositif de commande (STE) est conçu pour effectuer répétitivement la mesure du bruit sur la chaîne de réception.

18. Terminal de communication selon la revendication 17, dans lequel le dispositif de commande (STE) est conçu pour effectuer la mesure du bruit à des intervalles réguliers dans le temps.

19. Terminal de communication selon l'une des revendications 14 à 18, dans lequel le dispositif émetteur (SEM) est en mesure de faire varier la fréquence d'émission utilisée pour émettre les signaux radio, le dispositif de commande effectuant alors la mesure du bruit après que le dispositif émetteur a modifié la fréquence d'émission.

20. Terminal de communication selon l'une des revendications 14 à 19, dans lequel le dispositif émetteur (SEM) est en mesure de faire varier la puissance d'émission utilisée pour émettre les signaux radio, le dispositif de commande (STE) effectuant alors la mesure du bruit après que le dispositif émetteur a modifié la puissance d'émission.

21. Terminal de communication selon l'une des revendications 14 à 20, dans lequel la chaîne de réception est en mesure de faire varier dans la bande de fréquences la fréquence de réception sur laquelle est reçu un service radio défini, le dispositif de commande (STE) effectuant alors la mesure du bruit après que la chaîne de réception a modifié la fréquence de réception.

22. Terminal de communication selon l'une des revendications 14 à 21, dans lequel le dispositif de commande, avant d'exécuter la mesure du bruit, règle l'amplification (VS) du dispositif amplificateur à une valeur maximale possible à laquelle il ne se produit pas de destruction du composant récepteur pendant la mesure.

23. Terminal de communication selon l'une des revendications 14 à 22, dans lequel la chaîne de réception comporte en outre un filtre passe-bande (BPF) réglable pour laisser passer une bande de fréquences souhaitée, le dispositif de commande (STE) réglant le filtre passe-bande en termes de bande de fréquences en fonction du bruit mesuré de telle manière que le bruit causé par l'émission des signaux radio soit rendu minimal sur la chaîne de réception.

24. Terminal de communication selon l'une des revendications 14 à 23, dans lequel la chaîne de réception (EK3) comporte en outre une antenne accordable (ANTD) pour recevoir une bande de fréquences souhaitée, le dispositif de commande (STE) réglant l'antenne en termes de bande de fréquences en fonction du bruit mesuré de telle manière que le bruit causé par l'émission des signaux radio soit rendu minimal sur la chaîne de réception.

25. Terminal de communication selon l'une des revendications 14 à 24, dans lequel les propriétés spectrales du bruit sont en outre déterminées lors de la mesure du bruit, le dispositif de commande réglant la linéarité du dispositif amplificateur en fonction des maxima spectraux déterminés.

26. Terminal de communication selon l'une des revendications 14 à 25, dans lequel le dispositif d'émission (SEM) comprend en outre un filtre de fréquences d'émission (FI) commutable, le dispositif de commande (STE) plaçant le filtre de fréquences d'émission sur le trajet d'émission du dispositif d'émission en fonction du bruit mesuré, de manière que le bruit causé par l'émission des signaux radio (FST) sur la chaîne de réception soit rendu minimal.

27. Terminal de communication selon l'une des revendications 14 à 26, prenant la forme d'un appareil portatif.

28. Terminal de communication selon la revendication 27, prenant la forme d'un appareil radio mobile, d'un téléphone mobile (MFG) ou d'un ordinateur portatif avec module radio.
